(19) **Europäisches Patentamt**
**European Patent Office**
**Office européen des brevets**

(11) **EP 1 522 142 B1**

(12) **EUROPÄISCHE PATENTSCHRIFT**

(45) Veröffentlichungstag und Bekanntmachung des Hinweises auf die Patenterteilung:
**28.11.2007 Patentblatt 2007/48**

(21) Anmeldenummer: **03763596.8**

(22) Anmeldetag: **08.07.2003**

(51) Int Cl.:
***H03G 1/00*** *(2006.01)*

(86) Internationale Anmeldenummer:
**PCT/DE2003/002286**

(87) Internationale Veröffentlichungsnummer:
**WO 2004/008630 (22.01.2004 Gazette 2004/04)**

(54) **VERSTÄRKERSCHALTUNG MIT EINSTELLBARER VERSTÄRKUNG UND SENDEANORDNUNG MIT DER VERSTÄRKERSCHALTUNG**

AMPLIFYING CIRCUIT WITH ADJUSTABLE AMPLIFICATION AND TRANSMITTER SYSTEM COMPRISING SUCH AN AMPLIFYING CIRCUIT

CIRCUIT AMPLIFICATEUR A AMPLIFICATION REGLABLE ET SYSTEME EMETTEUR COMPRENANT UN TEL CIRCUIT AMPLIFICATEUR

(84) Benannte Vertragsstaaten:
**DE FR GB**

(30) Priorität: **10.07.2002 DE 10231181**

(43) Veröffentlichungstag der Anmeldung:
**13.04.2005 Patentblatt 2005/15**

(73) Patentinhaber: **Infineon Technologies AG**
**81669 München (DE)**

(72) Erfinder:
• **HEIGELMAYER, Bernhard**
**A-4020 Linz (AT)**

• **PRETL, Harald**
**A-4311 Schwertberg (AT)**

(74) Vertreter: **Epping - Hermann - Fischer**
**Ridlerstrasse 55**
**80339 München (DE)**

(56) Entgegenhaltungen:
**EP-A- 0 810 723          WO-A-01/41302**
**US-A- 5 926 068          US-A- 5 977 828**
**US-B1- 6 373 337**

**Beschreibung**

Die vorliegende Erfindung betrifft eine Verstärkerschaltung mit einstellbarer Verstärkung und eine Sendeanordnung mit der Verstärkerschaltung.

In der Hochfrequenztechnik kommen ausgangsseitig im Sendepfad normalerweise sogenannte RF-Leistungsverstärker zum Einsatz. Beispielsweise bei Mobilfunkgeräten der dritten Generation, welche für UMTS (Universal Mobile Telecommunications Standard) ausgelegt sind, müssen auf einer Trägerfrequenzebene von ca. 2 Ghz sogenannte W-CDMA (Wide-Band Code Division Multiple Access)-Signale mit einer Bandbreite von zwei Megahertz über eine exponentielle Kennlinie verstärkt werden. Eine derartige, exponentielle Übertragungscharakteristik ist typisch für Variable Gain Amplifier, VGA und kann bei halblogarithmischer Darstellung als Gerade aufgetragen werden. Dabei wird normalerweise die Ausgangsleistung in Dezibel über der Steuerspannung des Verstärkers in Volt aufgetragen.

An derartige, einstellbare Hochfrequenzverstärker werden hohe Anforderungen bezüglich Stromverbrauch, Wirkungsgrad, Linearität, Rauschen und Chipflächenbedarf gestellt. Letztere Anforderung führt zu Problemen des Übersprechens und in der Hochfrequenztechnik insbesondere zu unerwünschtem Durchscheinen von Trägerfrequenzen, Selbstmischeffekten et cetera. Der Stromverbrauch soll normalerweise deshalb gering sein, da derartige Mobilfunkgeräte normalerweise aus Batterien oder Akkumulatoren gespeist werden.

Leistungsverstärker im Hochfrequenzbereich werden normalerweise als induktiv degenerierte, in bipolarer Schaltungstechnik aufgebaute Differenzverstärker mit aufgeschalteter Stromkaskode realisiert.

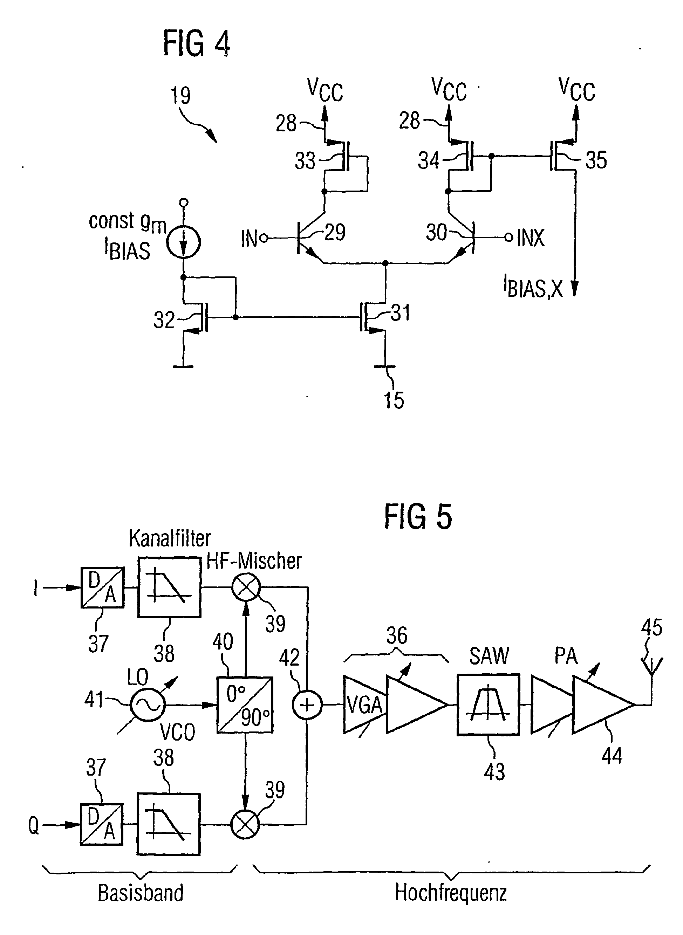

Ein derartiger Differenzverstärker ist beispielsweise in dem Dokument P. R. Gray, R. G. Meyer "Analysis and Design of Analog Integrated Circuits", John Wiley and Sons, 1993, Seiten 377 bis 378 sowie 511 bis 513 angegeben, vergleiche dort beispielsweise Figur 5-10. Dieser Differenzverstärker ist insbesondere in Bezug auf die große Verstärkung, die hohen Grenzfrequenzen, das geringe Eigenrauschen und der guten Linearität auf Grund der induktiven Degenerierung vorteilhaft einsetzbar. Der Ausgang der Kaskodestufe wird dabei in integrierten Sendeschaltungen normalerweise als offener Kollektorausgang realisiert. Als Lastwiderstand wird normalerweise ein Oberflächenwellenfilter an eine derartige Leistungsverstärkerstufe angeschlossen, welche dessen ohmsche Last repräsentiert. Dies dient zur Unterdrückung unerwünschter Signalanteile. Ein eventuell erforderliches Anpaßnetzwerk am Ausgang des offenen Kollektorausgangs wird dabei normalerweise extern angeschlossen.

Die induktive Degenerierung des Differenzverstärkers mit zwischen dem gemeinsamen Emitterknoten des Verstärkers und den Emitteranschlüssen der beiden Differenzverstärkertransistoren geschalteten Induktivitäten bewirkt die erwünschte Stromgegenkopplung, welche bei hoher Güte ein nur geringes Eigenrauschen im Gesamtsystem bewirkt und die Linearisierung der Übertragungsfunktion ermöglicht.

Bei der Verstärkung hochfrequenter Signale wirkt die Induktivität jedoch, insbesondere im GHz-Bereich, nachteilhafterweise als Antenne beziehungsweise Transformator und stellt somit ein unvermeidbares Problem für das Übersprechen von Signalen über das elektromagnetische Wechselfeld am integrierten Schaltkreis auf andere Schaltkreise dar. Ein weiteres Problem besteht in der Regelung der Leistungsabgabe des Verstärkers. Für die Verstärkung A gilt, daß A proportional ist zu dem Produkt aus $g_{m,red}$ und $R_{last}$, wobei $g_{m,red}$ die Transkonduktanz der in Emitterschaltung betriebenen Differenzverstärkertransistoren repräsentiert. $R_{last}$ ist der an den offenen Kollektorausgang angeschlossene Lastwiderstand. Dabei wurde die Verstärkung der Kaskodestufe zu eins angenommen. Die Steilheit wird im Wesentlichen durch den Kollektorstrom und den Wert der Emitter-Degenerierung im relevanten Hochfrequenzbereich bestimmt gemäß der Vorschrift:

$$g_{m,red} \approx \frac{1}{\dfrac{1}{g_m} + Z_L} \approx \frac{1}{\dfrac{U_T}{I_C} + Z_L}$$

mit $g_m$ gleich Steilheit, $Z_L$ gleich komplexer Degenerierungswiderstand, $I_C$ gleich Kollektorstrom und $U_T$ gleich Temperaturspannung.

Man erkennt, daß eine Steuerung der Leistungsabgabe des Verstärkers nur durch einen Eingriff in dessen Ruhestromzufuhr möglich ist, wodurch der Arbeitspunkt des Verstärkers entsprechend nachteilhaft verschoben würde. Bei einem verhältnismäßig großen Verstärkungsbereich würden hierbei aber unerwünschte Nichtlinearitäten des Differenzverstärkers zum Tragen kommen.

Das Dokument US 5,926,068 zeigt eine Verstärkeranordnung mit variabler Verstärkung, die mehrere parallel geschaltete Differenzverstärker und ein Logik-Mittel umfasst. Die Ausgänge der Differenzverstärker sind über weitere Transistoren mit dem Ausgang der Verstärkerschaltung verbunden. Die Verstärkertransistoren der jeweiligen Differenzverstärker werden von parallelgeschalteten Schalttransistoren angesteuert.

Das Dokument US 5,977,828 zeigt ebenfalls eine Verstärkeranordnung mit variabler Verstärkung. Sie umfasst mindestens drei Verstärkerelemente, die ein Signal mit verschiedenen Verstärkungsfaktoren verstärken können und die parallel zu einander angeordnet sind, und eine Kontrolleinheit. Eine Aktivierung der einzelnen Verstärkerstufen erfolgt über Zu- beziehungsweise Abschalten der Stromsenken der beiden Verstärkertransistoren einer Verstärkerstufe.

In dem Dokument A. B. Grebene "Bipolar and MOS Analog Integrated Circuit Design", John Wiley and Sons 1984 ist auf Seiten 444 bis 448 ein weitergebildeter Verstärker mit einem Strom-Shunting-Prinzip in der Kaskodestufe gezeigt. Dabei werden, vergleiche dort beispielsweise Figur 8.37, zwei Kaskodestufen parallel geschaltet, welche das Stromsignal des Verstärkers stufenlos vom Ausgang nach Versorgungsspannung umsteuern. Dies ist möglich, wenn man über einen zusätzlichen Steuerblock die Bias-Potentiale der Kaskodetransistoren linear verschiebt. Hierdurch ergibt sich mit

$$I_C = I_S \cdot \exp\left(\frac{U_{BE}}{U_T}\right)$$

eine exponentielle Kennlinie des Verstärkers für eine in halblogarithmischer Darstellung lineare Regelung. Der gravierenste Nachteil einer derartigen Leistungsregelung ist durch die konstante Stromaufnahme des Leistungsverstärkers gegeben. Nur unter Zuhilfenahme einer nicht unbedeutenden Hilfsenergiemenge für den Steuerblock ist es möglich, einen Stromsparmodus bereitzustellen. Der Verstärker selbst benötigt in jedem Punkt der Kennlinie eine konstante Leistung, wodurch sich der Wirkungsgrad der Gesamtschaltung beim Herunterregeln der Ausgangsleistung signifikant reduziert.

Aufgabe der vorliegenden Erfindung ist es, einen zur Verstärkung hochfrequenter Signale geeigneten Verstärker mit einstellbarer Verstärkung anzugeben, welcher einen großen einstellbaren Verstärkungsbereich hat, stromsparend arbeitet und ein unerwünschtes Übersprechen von Signalen verhindert.

Erfindungsgemäß wird die Aufgabe gelöst durch eine Verstärkerschaltung mit einstellbarer Verstärkung, aufweisend

- ein Eingang zur Zuführung eines Differenzsignals,
- einen Ausgang zum Ableiten eines verstärkten Signals,
- einen Steuereingang zum Zuführen eines Verstärkungsfaktors,
- eine Kaskodestufe, die an den Ausgang angeschlossen ist, umfassend zwei steuerseitig miteinander gekoppelte Kaskode-Transistoren,
- mehrere, parallelgeschaltete Differenzverstärker, mit je einem Eingang, der mit dem Eingang verbunden ist, mit je einem Ausgang, der mit der Kaskodestufe verbunden ist, und mit je einem Aktiviereingang, und
- eine Ansteuereinheit, mit einem Eingang, der an den Steuereingang der Verstärkerschaltung angeschlossen ist, und mit mehreren Ausgängen, von denen je einer mit je einem Differenzverstärker an dessen Aktiviereingang verbunden ist zum Aktivieren eines oder mehrerer Differenzverstärker in Abhängigkeit von dem am Steuereingang zugeführten Verstärkungsfaktor, wobei der einem Differenzverstärker zugeordnete Aktiviereingang mit einem Stromspiegeltransistor gekoppelt ist, der mit zwei Verstärkertransistoren des Differenzverstärkers jeweils einen Stromspiegel bildet zur Zuführung eines Referenzstroms in Abhängigkeit von einem am Aktiviereingang anliegenden Signal.

Die parallelgeschalteten Differenzverstärkerstufen, welche untereinander einen gleichartigen Schaltungsaufbau besitzen, sind mit ihren Ausgängen miteinander verbunden und an eine gemeinsame Kaskodestufe angeschlossen.

Bevorzugt arbeitet jede einzelne Verstärkerzelle in einem Arbeitspunkt, der bezüglich Linearität und Rauschen optimiert eingestellt ist. Die Differenzverstärker sind unabhängig von einander zu- und abschaltbar. Jede eingeschaltete Differenzverstärkerzelle liefert ihren Beitrag zur Gesamtverstärkung. Diese Beiträge, die bevorzugt als Stromanteile vorliegen, werden an dem Eingang der Kaskodestufe addiert und an den Ausgang der Kaskodestufe und damit den Ausgang der Verstärkerschaltung mit einstellbarer Verstärkung übertragen. Die Ansteuerung der einzelnen Differenzverstärker erfolgt über die Ansteuereinheit, welche nach einer vorbestimmten Zuordnungsvorschrift das eingangsseitige Steuersignal, beispielsweise eine Eingangsspannung, auf eine beliebige Kennlinie abbildet.

Bevorzugt wird die Steuerspannung auf eine exponentielle Leistungskennlinie durch entsprechendes Zu- und Abschalten einzelner Differenzverstärker auf eine exponentielle Leistungskennlinie abgebildet. Eine effiziente Stromausnutzung der Leistungsregelung wird dadurch erreicht, daß in einem bestimmten Kennlinienpunkt immer nur so viele Differenzverstärkerzellen eingeschaltet sind, wie zur Bereitstellung einer gewünschten Ausgangsleistung benötigt werden. Somit ist über den gesamten Verstärkungsbereich die Leistungsfähigkeit der vorliegenden Verstärkerschaltung bezüglich Rauschen, Linearität, Verzerrungen und Wirkungsgrad sichergestellt.

Die einzelnen parallel geschalteten Differenzverstärker haben bevorzugt einen gleichen Schaltungsaufbau.

Der beschriebene Aufbau der Verstärkerschaltung mit mehreren, parallel geschalteten Differenzverstärkerstufen, die eine gemeinsame Kaskodestufe speisen, ermöglicht es, ohne Nachteile auf Einsatz von Induktivitäten zur induktiven Degenerierung in den einzelnen Differenzverstärkerzellen vollständig zu verzichten. Somit ist die vorliegende Schaltung für höhere Integrationsdichten bei Frequenzen im Gigahertz-Bereich geeignet, da Probleme durch Übersprechen deutlich verringert sind.

Die Ansteuereinheit ist mit den Aktiviereingängen der parallel geschalteten Differenzverstärker bevorzugt über einen Stromspiegel mit Gegenkopplungswiderstand oder Biaswiderstand angeschlossen, der die Steuereingänge der Differenzverstärkertransistoren speist. Die Steuereingänge der Differenzverstärkertransistoren sind dabei über je einen Widerstand an einen gemeinsamen Knoten im Stromspiegel verbunden und arbeiten als Ausgangstransistoren des Stromspiegels.

Das hochfrequente, zu verstärkende Signal wird bevorzugt über eine durch Serienkondensatoren realisierte Wechselstromkopplung eingespeist.

Der Differenzverstärker ist bevorzugt in Common-Source-Schaltung aufgebaut, das heißt, daß die Source- oder Emitter-Anschlüsse der Differenzverstärkertransistoren miteinander verbunden sind.

Der Arbeitspunkt wird bevorzugt über die Biaswiderstände und den Stromspiegel eingestellt. Somit fällt die Funktion der Stromquellen und des Verstärkers in den beiden Differenzverstärkertransistoren zusammen, so daß das Ausgangssignal einen großen Aussteuerbereich hat.

Die Verstärkertransistoren sind bevorzugt als Feldeffekttransistoren ausgeführt. Die Kaskode-Transistoren, welche für alle Differenzverstärker eine gemeinsame Kaskodestufe bilden, sind bevorzugt in bipolarer Schaltungstechnik ausgeführt.

Hierdurch werden die Linearitätseigenschaften des Verstärkers weiter deutlich verbessert. Auf Grund der Niederohmigkeit an den Emittereingängen der Kaskodetransistoren wird der Spannungshub an den Drainanschlüssen der Verstärkertransistoren weitgehend unterdrückt, das Stromsignal selbst erzeugt erst am hochohmigen Kollektorausgang der Kaskode seinen Spannungshub an einer anzuschließenden Last.

Die Ansteuerung des Aktiviereingangs der einzelnen Differenzverstärker erfolgt bevorzugt durch je einen zugeordneten Komparator, der in der Ansteuereinheit vorgesehen ist. Den Komparatoren wird an je einem Eingang das Soll-Signal mit der gewünschten Verstärkung der Verstärkerschaltung und an je einem anderen Eingang ein jeweiliger, abgestufter Schwellwert zugeführt.

Diese Vergleichsspannungen oder Vergleichssignale sind bevorzugt exponentiell abgestuft und werden beispielsweise durch eine Widerstandskette, die einen Spannungsteiler bildet, bereitgestellt.

Die Komparatoren sind bevorzugt in bipolarer Schaltungstechnik ausgeführt. Hierdurch werden die Differenzverstärker gemäß einer Tangens Hyperbolicus-Kennlinie eingeschaltet, wodurch sich ein besonders sanfter Übergang entlang der gewünschten Ausgangskennlinie mit mäßiger Steilheit ergibt. Somit sind insbesondere nachteilhafte Auswirkungen auf übergeordnete Regelschleifen, in denen die vorliegende Verstärkerschaltung angeordnet werden kann, ausgeschlossen.

Anstelle der exponentiell abgestuften Schwellwerte als Vergleichpotentiale für die Komparatoren ist es auch möglich, eine lineare Abstufung der Schwellwerte einzusetzen und die Gewichtung der Verstärkungsbeiträge der einzelnen Differenzverstärkerzellen entsprechend zu verändern, so daß insgesamt ebenfalls eine exponentielle Kennlinie des Verstärkers resultiert.

Allgemein kann mit dem vorgestellten Prinzip eine beliebige, beispielsweise eine logarithmische, lineare oder exponentielle Kennlinie der Ausgangsleistung in Abhängigkeit von der Steuerspannung erzeugt werden.

Der vorliegende Verstärker ist insbesondere zur Anwendung in Mobilfunksendern mit Direktumsetzung des Basisbands in die Hochfrequenzebene geeignet und zur Anwendung in Geräten gemäß UMTS (Universal Mobile Telecommunications Standard), welche mit Code-Vielfachzugriffsverfahren (CDMA) arbeiten, vorgesehen.

Weitere Einzelheiten und vorteilhafte Ausgestaltungen der vorliegenden Erfindung sind Gegenstand der Unteransprüche.

Die Erfindung wird nachfolgend anhand von Ausführungsbeispielen an mehreren Zeichnungen näher erläutert. Es zeigen:

Figur 1    ein Ausführungsbeispiel der vorliegenden Erfindung anhand eines Blockschaltbildes,

Figur 2    eine beispielhafte Ausführung der Verstärkerzellen von Figur 1 anhand eines Schaltplanes,

Figur 3    eine Weiterbildung der Verstärkerschaltung von Figur 1 mit Komparatoren zur Ansteuerung der Differenzverstärker,

Figur 4    eine beispielhafte Ausführung eines Komparators von Figur 3 anhand eines Schaltplanes,

Figur 5    ein Blockschaltbild eines Sendepfades mit der Verstärkerschaltung von Figur 1 oder 3,

Figur 6    die Kennlinie der Ausgangsleistung aufgetragen über der Steuerspannung in linearer Darstellung gemäß der Verstärkerschaltung von Figur 3 und

Figur 7    das Schaubild von Figur 6, jedoch in halblogarithmischer Darstellung.

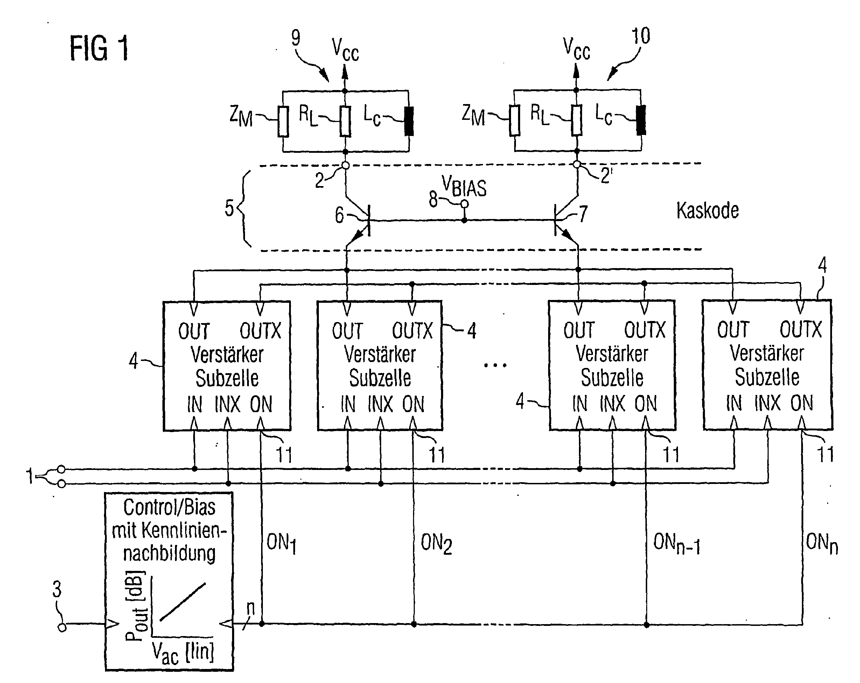

Figur 1 zeigt eine Verstärkerschaltung mit einstellbarem Verstärkungswert. Diese weist einen Nutzsignaleingang 1 zum Zuführen eines differentiellen Nutzsignals auf, der als Eingang ausgebildet ist. Das verstärkte Nutzsignal kann am Ausgangsklemmenpaar 2, 2' des Verstärkers abgeleitet werden. An einem Steuereingang 3 ist ein Soll-Signal für einen gewünschten Verstärkungswert des Verstärkers als Spannungssignal zuführbar. An dem Eingang 1 sind mit ihren jeweiligen Eingängen mehrere, miteinander in einer Parallelschaltung verschaltete Differenzverstärker 4 angeschlossen. An deren ebenfalls differentiell ausgeführten Ausgangsklemmenpaaren, welche miteinander verbunden sind, ist eine gemeinsame Kaskodestufe 5 angeschlossen, welche zwei Kaskodetransistoren 6, 7 umfaßt. Die Kaskodetransistoren 6, 7 sind in bipolarer Schaltungstechnik ausgeführt und mit ihren Basisanschlüssen miteinander und einem Bias-spannungseingang 8 verbunden. Das Emitterausgangs-paar ist mit den Ausgangsklemmenpaaren der Differenzverstärker 4 verbunden. Das Kollektoranschlußpaar der npn-Transistoren 6, 7 bildet das Ausgangsklemmenpaar 2, 2' des Verstärkers. An den Verstärkerausgang 2, 2' sind externe, elektrische Lasten 9, 10 angeschlossen. Die externen, elektrischen Lasten 9, 10 sind beispielhaft und in vereinfachter Darstellung jeweils als Parallelschaltungen einer ohmschen Last $R_L$, einer komplexen Last $Z_M$ sowie einer Induktivität $L_C$ ausgeführt. Die Differenzverstärker 4 weisen neben ihrem Eingang und ihrem Ausgangsklemmenpaar, welche jeweils miteinander parallel geschaltet sind, weiterhin je einen Aktiviereingang 11 auf. Die Aktiviereingänge 11 der Differenzverstärker 4 sind an je einen zugeordneten Ausgang einer Ansteuereinheit 12 angeschlossen, welche eingangsseitig mit dem Steuereingang 3 verbunden ist und in Abhängigkeit von einem anliegenden Steuersignal einen oder mehrere der getrennt voneinander zu- und abschaltbaren Differenzverstärkerzellen 4 aktiviert.

Jede Differenzverstärkerzelle 4 verarbeitet in ihrem für Linearität und Rauschen optimierten Betriebspunkt das gleiche Eingangssignal und liefert ihren Beitrag für die Gesamtverstärkung. Diese Strombeiträge werden am niederohmigen Eingang der Kaskode 5 addiert und in den Off-chip-Lastwiderständen 9, 10 in Leistung umgesetzt. Die Ansteuerung der einzelnen Differenzverstärkerzellen 4 erfolgt über die Ansteuereinheit 12, welche nach einer vorbestimmten Zuordnungsvorschrift im allgemeinen Fall ein eingangsseitiges Steuersignal auf eine beliebige Kennlinie, vorliegend eine exponentielle Leistungskennlinie abbildet. Die Aktivierung der Differenzverstärker 4 erfolgt dabei über deren Ruhestromzuführung, englisch Bias.

Die beschriebene Verstärkerschaltung bietet einen großen einstellbaren Verstärkungsbereich, gute Rauscheigenschaften, sowie gute Linearitätseigenschaften bezüglich Verzerrungen. Außerdem ist der Strombedarf auf Grund der gezeigten Struktur stets an die aktuelle Leistungsabgabe angepaßt. Da somit in den einzelnen Differenzverstärkern 4 auf induktive Degeneration verzichtet werden kann, ist auch das Übersprechen gering und die Hochfrequenzeigenschaften sind auch im Gigahertz-Bereich gut.

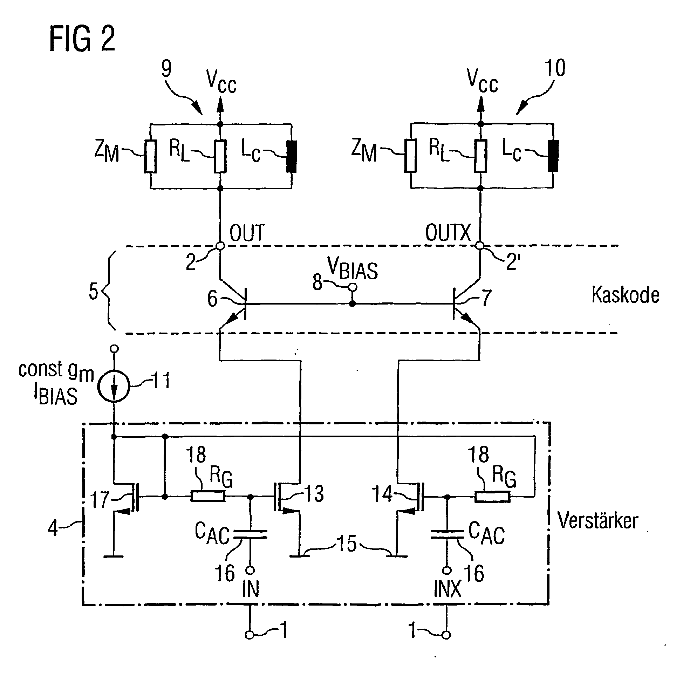

Figur 2 zeigt den schaltungstechnischen Aufbau der Differenzverstärkerzellen 4. Diese Differenzverstärkerzellen 4 von Figur 1 haben alle den gleichen schaltungstechnischen Aufbau.

Der eigentliche Differenzverstärker ist von zwei n-Kanal MOS-Feldeffekttransistoren 13, 14 gebildet, deren Drainanschlüsse an je einen Emitteranschluß der Kaskodetransistoren 6, 7 und deren Source-Anschlüsse am Bezugspotentialanschluß 15 angeschaltet sind. Die Gate-Anschlüsse der Differenzverstärkertransistoren 13, 14 sind über Serien-Koppelkapazitäten 16, welche Hochpaßeigenschaften bieten, an den Nutzsignaleingang 1 angeschlossen. Außerdem ist zur Arbeitspunkteinstellung ein Stromspiegel vorgesehen mit einem Stromspiegeltransistor 17, der ebenfalls als n-Kanal-Feldeffekttransistor ausgebildet und als Diode verschaltet ist. Der Gate-Anschluß des Stromspiegeltransistors 17 ist über je einen Biaswiderstand 18 mit den beiden Gate-Anschlüssen der Differenzverstärkertransistoren 13, 14 verbunden. Der Drain-Anschluß des Stromspiegeltransistors 17, der mit dem Gate-Anschluß desselben verbunden ist, bildet den Aktiviereingang 11 des Differenzverstärkers 4.

Die externe elektrische Last umfaßt wie bei Figur 1 eine Spule $L_C$, die für das Schwingen der Ausgangsspannung um die Betriebsspannung VCC nötig ist, einen ohmschen Lastwiderstand $R_L$, der ein Oberflächenwellen-Bandpaßfilter repräsentiert, welches dem Verstärker nachgeschaltet ist, sowie eine komplexe Last $Z_M$, welche ein Anpaßnetzwerk repräsentiert.

Man erkennt, daß die Differenzverstärker 4 mit Vorteil ohne Induktivitäten auskommen.

Das hochfrequente, zu verstärkende Nutzsignal wird über die Koppelkapazitäten 16 eingespeist und moduliert den in Common-Source-Schaltung betriebenen Verstärker 13, 14. Dessen Arbeitspunkt wird mit dem Stromspiegeltransistor 17 und den Widerständen 18 eingestellt. Vorteilhafterweise fallen die Funktionen der Stromquelle und des Verstärkers in den Transistoren 13, 14 zusammen, was sich insbesondere vorteilhaft auf den Aussteuerbereich des Ausgangssignals auswirkt. Die ausreichende Linearität des Verstärkers ist dadurch sichergestellt, daß an den Transistoren 13, 14 eine ausreichende O-verdrive-Spannung eingestellt ist. Somit ist ein Verhältnis von Signalstrom zu Ruhestrom von kleiner 1 während des Betriebes gewährleistet. Durch die Niederohmigkeit am Emittereingang der Kaskodetransistoren 6, 7 wird der Spannungshub an den Drainanschlüssen der Verstärkertransistoren 13, 14 weitgehend unterdrückt. Das Stromsignal selbst erzeugt erst am hochohmigen Kollektorausgang der Kaskodestufe 6, 7 seinen Spannungshub an der elektrischen Last 9, 10. Damit die gewünschte Verstärkung auch über den gesamten Einsatztemperaturbereich garantiert werden kann, wird ein Ruhestromsignal mit konstantem $g_m$ verwendet, welches von der Ansteuerschaltung 12 bereitgestellt wird. In der Differenzverstärkerschaltung 4 wird der für eine konstante Ausgangsleistung benötigte konstante Steilheitswert $g_m$ über einen Widerstandswert eingestellt und durch den Einsatz eines Reglers fixiert.

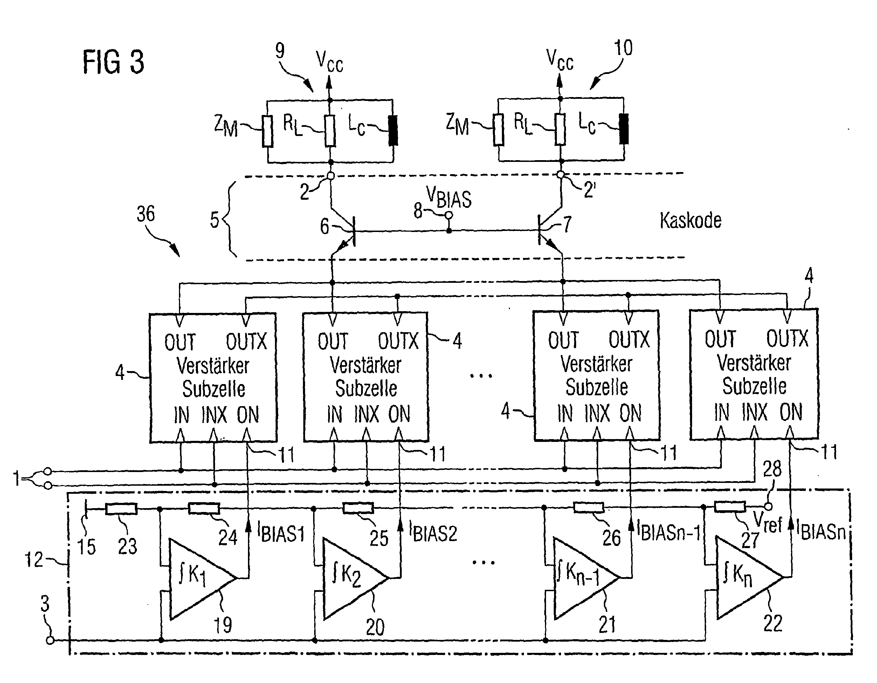

Figur 3 zeigt eine Weiterbildung der Verstärkerschaltung mit einstellbarer Verstärkung von Figur 1, bei der die Ansteuerschaltung 12 der Differenzverstärker 4 anhand eines Ausführungsbeispiels detailliert gezeichnet ist. Alle übrigen Bauteile, deren Funktionsweise, ihre Verschaltung miteinander und die vorteilhafte Funktionsweise der Verstärkerschaltung insgesamt entsprechen denen von Figur 1 und werden daher an dieser Stelle nicht noch einmal wiederholt.

Die Ansteuerschaltung 12 umfaßt Komparatoren, von denen je einer je einem Differenzverstärker 4 zugeordnet ist. Die Komparatoren sind mit Bezugszeichen 19 bis 22 versehen. Die Komparatoren 19 bis 22 haben je einen Ausgang, der mit dem Aktiviereingang 11 des zugeordneten Differenzverstärkers 4 zur Zuführung eines den jeweiligen Differenzverstärker 4 aktivierenden Ruhestromes verbunden sind. Die Komparatoren 19 bis 22 haben je zwei Eingänge. Je ein erster Eingang der Komparatoren 19 bis 22 ist mit dem Steuereingang 3 des Verstärkers verbunden, an dem der Verstärkungswert des Verstärkers eingestellt wird. Die zweiten Eingänge der Komparatoren 19 bis 22 sind mit je einem Abgriffsknoten einer Widerstandskette 23 bis 27 verbunden, die zwischen das Bezugspotential 15 und einen Versorgungspotentialanschluß 28 geschaltet ist. Die Widerstände 23 bis 27 sind bezüglich ihrer Werte exponentiell abgestuft, so daß an den Abgriffknoten exponentiell abgestufte Schwellwertpotentiale für die Komparatoren 19 bis 22 bereitstehen. Somit ist das exponentielle Verhalten des Verstärkers mit den bereits ausführlich erläuterten Vorteilen sichergestellt.

Figur 4 zeigt anhand eines detaillierten Schaltplanes den Komparator 19 von Figur 3. Einen ebensolchen Aufbau wie in Figur 4 gezeigt haben auch die Komparatoren 20 bis 22 von Figur 3. Der Kern des Komparators 19 umfaßt zwei npn-Bipolartransistoren, welche als Differenztransistoren 29, 30 des Komparators verschaltet und emitterseitig miteinander verbunden sind. Der gemeinsame Emitterknoten ist über einen n-Kanal-Feldeffekttransistor 31, der als Stromquelle arbeitet, gegen Bezugspotential 15 geschaltet. Der Stromquellentransistor 31 bildet mit einem als Diode verschalteten Transistor 32 einen Stromspiegel, an dessen Eingang ein Ruhestrom zugeführt wird, der in den Verstärkertransistoren einen konstanten $g_m$-Wert bewirkt. Kollektorseitig sind die Differenztransistoren 29, 30 des Komparators 19 über je eine Diode 33, 34 an Versorgungspotentialanschluß 28 geschaltet. An einer der beiden Dioden wird dabei das Ausgangssignal des Komparators 29, 30 über einen Stromspiegel ausgekoppelt, den ein weiterer MOS-Transistor 35 zusammen mit der Diode 34 bildet. Der Drain-Anschluß des Stromspiegeltransistors 35 ist mit einem Aktiviereingang 11 eines hier nicht eingezeichneten Differenzverstärkers 4 verbunden zur Aktivierung desselben, wie in Figur 3 gezeigt.

Insgesamt ist der Komparator 19 in BiCMOS-Schaltungstechnik aufgebaut.

Auf Grund des Einsatzes von bipolarer Schaltungstechnik in dem Kern des Komparators 19 und der übrigen Komparatoren 20 bis 22 erfolgt das Aktivieren der Differenzverstärker 4 gemäß einer Tangens-Hyperbolicus-Kennlinie, wodurch sich mit Vorteil ein besonders sanfter Übergang entlang der gewünschten Ausgangskennlinie mit mäßiger Steilheit der Verstärkungskennlinie ergibt.

Figur 5 zeigt eine bevorzugte Anwendung der Verstärkerschaltung mit einstellbarer Verstärkung 36 von Figur 3 im Sendepfad eines Mobilfunkgerätes. Es handelt sich vorliegend um einen Direktumsetzer mit komplexwertiger Signalverarbeitung, der in seiner Basisbandeinheit einen Inphase- und einen Quadraturpfad I, Q zur komplexwertigen Signalverarbeitung eines in orthogonale Komponenten zerlegten, komplexen Nutzsignals hat. I- und Q-Pfad umfassen je einen Digital/Analog-Wandler 37 mit nachgeschaltetem Tiefpaßfilter 38, welche an je einen ersten Eingang einer Mischerzelle 39 eines Quadraturmischers angeschlossen sind. Die jeweils zweiten Eingänge der Mischerzellen 39 sind über einen 0/90 Grad-Phasenschieber 40 an einen verstellbaren Frequenzgenerator 41, der ein Lokaloszillatorsignal erzeugt, angeschlossen. Der Quadraturmischer 39, 40 umfaßt ein die Mischerzellen 39 an ihren Ausgängen miteinander verbindendes Summierglied 42. Am Ausgang des Quadraturmischers 39, 40, 42 steht demnach ein moduliertes Trägersignal auf einer Hochfrequenzebene bereit. Dieses wird, je nach gewünschter Sendeleistung oder abhängig von Sollwerten in Regelschleifen, in der Verstärkerschaltung 36 mit einstellbarer Verstärkung in gewünschter Weise verstärkt und in einem nachgeschalteten Oberflächenwellenfilter 43 bandpaßgefiltert. Der Ausgang des Bandpaßfilters 43 ist über einen Leistungsverstärker 44 an eine Sendeantenne 45 angeschlossen.

In einem derartigen Direktumsetzer kommen die Vorteile des vorliegenden Verstärkers, wie hohe Linearität, geringe Verzerrungen, hohe Integrierbarkeit bei geringem Übersprechen und geringer an die aktuelle Leistungsabgabe angepaßter Stromverbrauch besonders vorteilhaft zum Tragen.

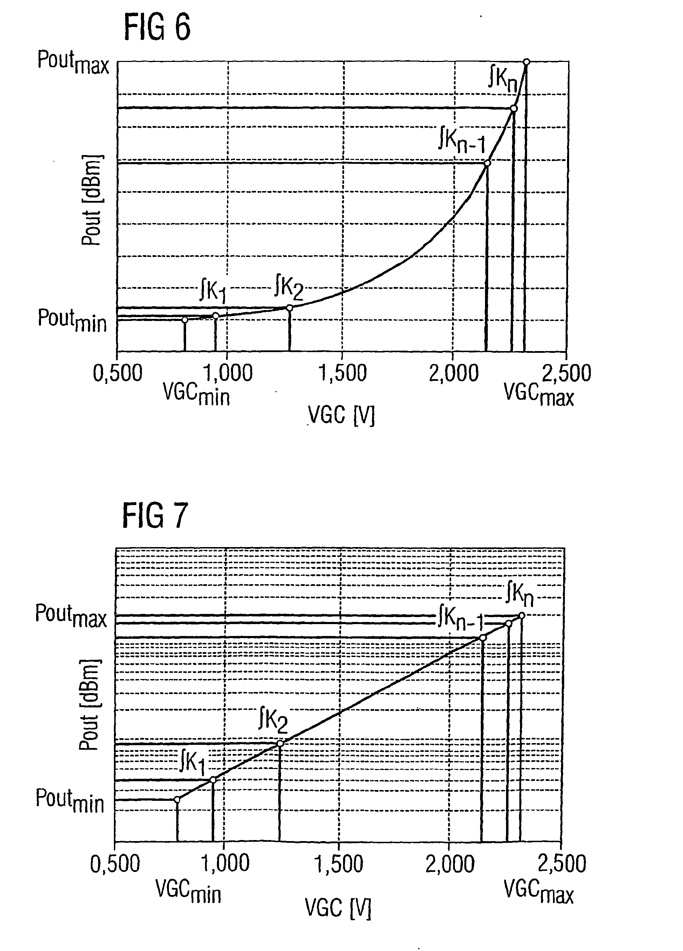

Figur 6 zeigt an Hand eines Schaubildes mit linearer Darstellung die Ausgangsleistung des Verstärkers von Figur 3 in mW aufgetragen über dem Spannungswert des Steuersignals anliegend an Steuereingang 3. Man erkennt deutlich die Umschaltschwellen der einzelnen Komparatoren 19 bis 22 und den gewünschten exponentiellen Verlauf der Kennlinie. Die Genauigkeit der Exponentialfunktion der Kennlinie ist an Hand der nachfolgenden Zeichnung noch deutlicher sichtbar.

Figur 7 zeigt den Kennlinienverlauf der Figur 6, jedoch aufgetragen in halblogarithmischer Darstellung. Dabei ist die Ausgangsleistung in dBmW aufgetragen über der Steuerspannung in Volt. Es ergibt sich ein an Hand einer Geraden aufgetragener, linearer Zusammenhang zwischen Steuerspannung und Ausgangsleistung in dB. Auch bei der Darstellung von Figur 7 sind die Umschaltschwellen der einzelnen Komparatoren, die die Differenzverstärker 4 aktivieren, eingezeichnet.

Bezugszeichenliste

| 1 | Eingang |
| 2 | Ausgang |
| 2' | Ausgang |
| 3 | Steuereingang |
| 4 | Differenzverstärker |

5 Kaskode
6 Kaskodetransistor
7 Kaskodetransistor
8 Bias-Eingang
9 elektrische Last
10 elektrische Last
11 Aktiviereingang
12 Ansteuereinheit
13 Verstärkertransistor
14 Verstärkertransistor
15 Masse
16 Wechselstromkopplung
17 Diode
18 Widerstand
19 Komparator
20 Komparator
21 Komparator
22 Komparator
23 Widerstand
24 Widerstand
25 Widerstand
26 Widerstand
27 Widerstand
28 Versorgungspotential
29 Differenztransistor
30 Differenztransistor
31 Stromspiegel
32 Stromspiegel
33 Diode
34 Diode
35 Stromspiegel
36 Verstärker
37 DAC
38 Tiefpaßfilter
39 Mischer
40 Phasenschieber
41 VCO
42 Summierglied
43 SAW-Filter
44 Leistungsverstärker
45 Antenne

**Patentansprüche**

1. Verstärkerschaltung mit einstellbarer Verstärkung, aufweisend

   - ein Eingang (1) zur Zuführung eines Differenzsignals,
   - einen Ausgang (2, 2') zum Ableiten eines verstärkten Signals,
   - einen Steuereingang (3) zum Zuführen eines Verstärkungsfaktors,
   - eine Kaskodestufe (5), die an den Ausgang (2, 2') angeschlossen ist, umfassend zwei steuerseitig miteinander gekoppelte Kaskode-Transistoren (6, 7),

   - mehrere, parallelgeschaltete Differenzverstärker (4), mit je einem Eingang, der mit dem Eingang (1) verbunden ist, mit je einem Ausgang, der mit der Kaskodestufe (5) verbunden ist, und mit je einem Aktiviereingang (11), und
   - eine Ansteuereinheit (12), mit einem Eingang, der an den Steuereingang (3) der Verstärkerschaltung angeschlossen ist, und mit mehreren Ausgängen, von denen je einer mit je einem Differenzverstärker (4) an dessen Aktiviereingang (11) verbunden ist zum Aktivieren eines oder mehrerer Differenzverstärker (4) in Abhängigkeit von dem am Steuereingang (3) zugeführten Verstärkungsfaktor,

   **dadurch gekennzeichnet, dass**
   der einem Differenzverstärker (4) zugeordnete Aktiviereingang (11) mit einem Stromspiegeltransistor (17) gekoppelt ist, der mit zwei Verstärkertransistoren (13, 14) des Differenzverstärkers jeweils einen Stromspiegel bildet zur Zuführung eines Referenzstroms in Abhängigkeit von einem am Aktiviereingang (11) anliegenden Signal.

2. Verstärkerschaltung nach Anspruch 1,
   **dadurch gekennzeichnet, daß**
   die jeweils zwei Verstärkertransistoren (13, 14) der Differenzverstärker (4) jeweils einen Steuereingang und eine gesteuerte Strecke umfassen, wobei die Steuereingänge des Differenzverstärkers (13, 14) mit dem Eingang (1) der Verstärkerschaltung gekoppelt sind und die gesteuerten Strecken je einen zugeordneten Kaskode-Transistor (6, 7) mit einem Bezugspotentialanschluß koppeln.

3. Verstärkerschaltung Anspruch 1 oder 2,
   **dadurch gekennzeichnet, daß**
   die Verstärkertransistoren (13, 14) als Feldeffekt-Transistoren und die Kaskode-Transistoren (6, 7) als Bipolartransistoren ausgeführt sind.

4. Verstärkerschaltung nach einem der Ansprüche 1 bis 3,
   **dadurch gekennzeichnet, daß**
   die Ansteuereinheit (12) mehrere Komparatoren (19, 20, 21, 22) umfaßt, von denen je einer mit seinem Ausgang an den Aktiviereingang (11) eines zugeordneten Differenzverstärkers (4) angeschlossen ist, wobei die Komparatoren (19, 20, 21, 22) jeweils einen ersten Eingang haben, der mit dem Steuereingang (3) der Verstärkerschaltung gekoppelt ist, und einen zweiten Eingang zum Zuführen eines jeweiligen, abgestuften Schwellwerts.

5. Verstärkerschaltung Anspruch 4,
   **dadurch gekennzeichnet, daß**
   eine Teilerkette (23, 24, 25, 26, 27) vorgesehen ist mit mehreren, exponentiell abgestuften Abgriffsknoten, von denen je einer mit einem zweiten Eingang eines zugeordneten Komparators (19, 20, 21, 22) verbunden ist zur Bereitstellung exponentiell abgestufter Schwellwerte.

6. Verstärkerschaltung Anspruch 4 oder 5,
   **dadurch gekennzeichnet, daß**
   die Komparatoren (19, 20, 21, 22) jeweils einen Differenzverstärker mit zwei Differenztransistoren (29, 30) umfassen, deren Steuereingänge die Eingänge des Komparators (19, 20, 21, 22) bilden, und daß der Ausgang des Komparators (19, 20, 21, 22) über einen Stromspiegel (34, 35) an einen der beiden Differenztransistoren (30) angekoppelt ist.

7. Verstärkerschaltung Anspruch 6,
   **dadurch gekennzeichnet, daß**
   die Differenztransistoren (29, 30) in bipolarer Schaltungstechnik ausgeführt sind.

8. Sendeanordnung mit einer Verstärkerschaltung nach einem der Ansprüche 1 bis 7, aufweisend

   - einen Hochfrequenzmischer (39, 40, 42) zum Umsetzen eines in Inphase- und Quadraturkomponente (I, Q) zerlegten Basisbandsignals in eine hochfrequente Lage und
   - die Verstärkerschaltung (36), deren Eingang an einen Ausgang des Hochfrequenzmischers angeschlossen ist, ausgebildet zum Verstärken eines hochfrequenten Signals mit einstellbarem Verstärkungsfaktor.

**Claims**

1. Amplifier circuit with adjustable gain, having

   - an input (1) for supplying a differential signal,
   - an output (2, 2') for deriving an amplified signal,
   - a control input (3) for supplying a gain factor,
   - a cascode stage (5) which is connected to the output (2, 2') and comprises two cascode transistors (6, 7) coupled to one another on the control side,
   - a plurality of differential amplifiers (4) connected in parallel, with a respective input which is connected to the input (1), with a respective output which is connected to the cascode stage (5), and with a respective activation input (11), and
   - an actuation unit (12), with an input which is connected to the control input (3) of the amplifier circuit, and with a plurality of outputs, a respective one of which is connected to the activation input (11) of a respective differential amplifier (4) for the purpose of activating one or more differential amplifiers (4) on the basis of the gain factor supplied at the control input (3),

**characterized in that**
the activation input (11) associated with a differential amplifier (4) being coupled to a current mirror transistor (17) which forms a respective current mirror together with two amplifier transistors (13, 14) in the differential amplifier in order to supply a reference current on the basis of a signal applied to the activation input (11).

2. Amplifier circuit according to Claim 1,
   **characterized in that**
   the respective two amplifier transistors (13, 14) in the differential amplifiers (4) each comprise a control input and a controlled section, the control inputs of the differential amplifier (13, 14) being coupled to the input (1) of the amplifier circuit, and the controlled sections each coupling an associated cascode transistor (6, 7) to a reference potential connection.

3. Amplifier circuit according to Claim 1 or 2,
   **characterized in that**
   the amplifier transistors (13, 14) are in the form of field effect transistors, and the cascode transistors (6, 7) are in the form of bipolar transistors.

4. Amplifier circuit according to one of Claims 1 to 3,
   **characterized in that**
   the actuation unit (12) comprises a plurality of comparators (19, 20, 21, 22), a respective one of which has its output connected to the activation input (11) of an associated differential amplifier (4), the comparators (19, 20, 21, 22) each having a first input, which is coupled to the control input (3) of the amplifier circuit, and a second input for supplying a respective, graduated threshold value.

5. Amplifier circuit according to Claim 4,
   **characterized in that**
   a divider chain (23, 24, 25, 26, 27) is provided which has a plurality of exponentially graduated tap nodes, a respective one of which is connected to a second input on an associated comparator (19, 20, 21, 22) in order to provide exponentially graduated threshold values.

6. Amplifier circuit according to Claim 4 or 5,
   **characterized in that**
   the comparators (19, 20, 21, 22) each comprise a differential amplifier with two differential transistors (29, 30) whose control inputs form the inputs of the comparator (19, 20, 21, 22), and
   **characterized in that** the output of the comparator (19, 20, 21, 22) is coupled to one of the two differential transistors (30) via a current mirror (34, 35).

7. Amplifier circuit according to Claim 6,
   **characterized in that**
   the differential transistors (29, 30) are produced using bipolar circuitry.

8. Transmission arrangement with an amplifier circuit according to one of Claims 1 to 7, having

   - a radio-frequency mixer (39, 40, 42) for converting a baseband signal, which has been split into inphase and quadrature components (I, Q), to a radiofrequency, and
   - the amplifier circuit (36), whose input is connected to an output on the radio-frequency mixer, designed to amplify a radio-frequency signal using an adjustable gain factor.

**Revendications**

1. Circuit amplificateur à amplification réglable, comportant :

   - une entrée(1) pour l'entrée d'un signal de différence,
   - une sortie (2, 2') pour la sortie d'un signal amplifié,
   - une entrée (3) de commande pour l'entrée d'un facteur d'amplification,
   - un étage (5) cascode qui est relié à la sortie (2, 2') et qui comprend deux transistors (6, 7) cascode couplés l'un à l'autre du côté commande,
   - plusieurs amplificateurs (4) différentiels montés en parallèle, ayant chacun une entrée qui est reliée à l'entrée (1), une sortie qui est reliée à l'étage (5) cascode et une entrée (5) d'activation et,
   - une unité (12) de commande, ayant une entrée qui est reliée à l'entrée (3) de commande du circuit amplificateur et ayant plusieurs sorties, dont l'une est reliée respectivement à un amplificateur (4) différentiel à son entrée (11) d'activation pour l'activation d'un ou de plusieurs amplificateurs (4) différentiels en fonction du facteur d'amplification entré par l'entrée (3) de commande,

   **caractérisée en ce que**,
   l'entrée (11) d'activation associée à un amplificateur (4) différentiel est couplée à un transistor(17) de miroir de courant, qui forme avec deux transistors (13, 14) de l'amplificateur différentiel respectivement un miroir de courant, pour envoyer un courant de référence en fonction d'un signal s'appliquant à l'entrée (11) d'activation.

2. Circuit amplificateur suivant la revendication 1, **caractérisé en ce que**
   les respectivement deux transistors (13, 14) de l'amplificateur (4) différentiel ont respectivement une entrée de commande et une section commandée, les entrées de commande de l'amplificateur (13, 14) différentiel étant couplées à l'entrée (1) du circuit amplificateur et les sections commandées couplant respectivement un transistor (6, 7) cascode associé à une borne de potentiel de référence.

3. Circuit amplificateur suivant la revendication 1 ou 2, **caractérisé en ce que** les transistors (13, 14) d'amplificateur sont réalisés sous la forme de transistors à effet de champ et les transistors (6, 7) cascode sous la forme de transistors bipolaires.

4. Circuit amplificateur selon l'une des revendications 1 à 3, **caractérisé en ce que** l'unité (12) de commande a plusieurs comparateurs (19, 20, 21, 22) dont respectivement l'un est relié par sa sortie à l'entrée (11) d'activation d'un amplificateur (4) différentiel associé, les comparateurs (19, 20, 21, 22) ayant respectivement une première entrée (3) qui est couplée à l'entrée (3) de commande du circuit amplificateur et une deuxième entrée pour l'entrée d'une valeur de seuil respective échelonnée.

5. Circuit amplificateur suivant la revendication 4, **caractérisé en ce qu'**il est prévu une chaîne (23, 24, 25, 26, 27) de diviseurs, ayant plusieurs noeuds de prélèvement échelonnés de façon exponentielle, dont l'un est relié respectivement à une deuxième entrée d'un comparateur (19, 20, 21, 22) associé pour mettre à disposition des valeurs de seuil échelonnées de façon exponentielle.

6. Circuit amplificateur suivant la revendication 4 ou 5, **caractérisé en ce que** les comparateurs (19, 20, 21,22) ont respectivement un amplificateur différentiel ayant deux transistors (29, 30) différentiels, dont les entrées de commande forment les entrées des comparateurs (19, 20, 21, 22), et **en ce que** la sortie du comparateur (19, 20, 21, 22) est couplée par un miroir de courant (34, 35) à l'un des deux transistors (30) différentiels.

7. Circuit amplificateur suivant la revendication 6, **caractérisé en ce que**,
   les transistors (29, 30) différentiels sont réalisés en technique de circuit bipolaire.

8. Dispositif d'émission ayant un circuit amplificateur selon l'une des revendications 1 à 7, comportant

   - un mélangeur (39, 40, 42) haute fréquence pour mettre un signal de bande de base décomposé en une composante en phase et en une composante en quadrature (I, Q) dans une position de haute fréquence et,

   le circuit (36) amplificateur, dont l'entrée est reliée à une sortie du mélangeur haute fréquence, est formé pour amplifier un signal de haute fréquence par un facteur d'amplification réglable.

# FIG 1

EP 1 522 142 B1

FIG 2

FIG 3

## FIG 4

## FIG 5

## FIG 6

## FIG 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5926068 A

- US 5977828 A

**In der Beschreibung aufgeführte Nicht-Patentliteratur**

- **P. R. GRAY ; R. G. MEYER.** Analysis and Design of Analog Integrated Circuits. John Wiley and Sons, 1993, 377-378577-513

- **A. B. GREBENE.** *Bipolar and MOS Analog Integrated Circuit Design,* 1984, 444-448